# EUROPÄISCHE PATENTSCHRIFT

(11) **EP 1 137 167 B1**
(45) Veröffentlichungstag und Bekanntmachung des Hinweises auf die Patenterteilung: **28.09.2005**
(21) Anmeldenummer: 00103652.4
(22) Anmeldetag: 21.02.2000
(51) Int. Cl.: H03C 1/36

(54) **Transponder**
Transponder
Transpondeur

(43) Veröffentlichungstag der Anmeldung: 26.09.2001
(73) Patentinhaber: Infineon Technologies AG, 81669 München (DE)
(72) Erfinder: Melcher, Gebhard, 8045 Weinitzen (AT); Kargl, Walter, 8020 Graz (AT)
(74) Vertreter: Epping - Hermann - Fischer

(56) Entgegenhaltungen:
- FR-A- 2 751 148
- FR-A- 2 751 149
- US-A- 5 621 412
- US-A- 5 712 630

## Beschreibung

Die vorliegende Erfindung betrifft eine Transponder aufweisend eine Modulationsschaltung mit einer Spule mit zwei Anschlüssen, an denen ein Gleichrichter angeschlossen ist, welche an seinen Ausgängen die Spannungsversorgung des Transponders bereitstellt, und einem Schalter-Transistor (M5), dessen erster Lastanschluß über je ein nichtlineares Bauelement an je einen Spulenanschluß angeschlossen ist, dessen zweiter Lastanschluß mit einem Bezugspotential verbunden ist, und dessen Steueranschluß ein Modulationssignal (MOD) zuführbar ist.

In Transponder-Schaltkreisen (Tags) wird ein von einer Station gesendetes Signal moduliert. Die für die Modulat.ionsschaltung erforderliche Energie wird hierbei aus dem elektrischen Feld bezogen. Daher benötigen solche Transponder keine Batterie. In einer Feststation wird das von dem Transponder-Schaltkreis modulierte Signal detektiert und ausgewertet. Praktische Anwendung finden solche Systeme beispielsweise in der Warenflußsteuerung, der Personenidentifizierung und der Zugangskontrolle.

Normalerweise haben Transponder-Schaltkreise eine Spule, welche der Kopplung des Transponders mit dem elektromagnetischen Feld dient. An diese Spule ist eine Gleichrichterschaltung zur Bereitstellung der Gleichspannungsversorgung der Transponderschaltung angeschlossen. Außerdem ist eine Schaltung zur Spannungsregelung vorgesehen, welche die in die Spule induzierte Spannung begrenzt. Ein vom Transponder generiertes Modulationssignal wird den beiden Spulenanschlüssen üblicherweise über lineare Bauelemente, beispielsweise Widerstände, zugeführt. Die Rückantwort des Transponders wird also über Serienwiderstände nach einer linearen Kennlinie abhängig von der Feldenergie erzeugt. Ein derartiger Transponder ist aus der FR-A-2 751 149 bekannt.

In der Praxis besteht das Problem, daß bei bestimmten, räumlichen Positionen des Transponders bezüglich der Station "Funklöcher" entstehen, das heißt, daß das vom Transponder generierte Signal zu schwach ist, um von der Station erfaßt zu werden. Außerdem ist die Reichweite, das heißt der maximale Abstand von Station und Transponder, begrenzt. Ein weiteres Problem ist dadurch gegeben, daß die Betriebsspannungen von Halbleiter-Schaltungen ständig kleiner werden.

Der Erfindung liegt die Aufgabe zugrunde, einen Transponder anzugeben, welcher bezüglich seiner Reichweite verbessert ist.

Erfindungsgemäß wird diese Aufgabe durch einen Transponder der eingangs genannten Art gelöst mit einem Spannungsregler aufweisend einen langsamen Regler mit einem Shunt-Transistor, dessen Steueranschluß ein langsames Regelsignal zuführbar ist, und dessen erster Lastanschluß mit dem Bezugspotential, und dessen zweiter Lastanschluß mit einem Knoten verbunden ist, wobei der Knoten über je eine Diode mit je einem Spulenanschluß verbunden ist, und aufweisend einen schnellen Spannungsregler, mit einem Hilfs-Transistor, dessen Steueranschluß ein schnelles Regelrsignal zuführbar ist und dessen erster Lastanschluß mit dem Knoten, und dessen zweiter Lastanschluß mit dem Steueranschluß des Shunt-Transistors verbunden ist.

Der Modulationsschaltung liegt also das Prinzip zugrunde, das im Transponder generierte Modulationssignal mittels elektronischer Bauelemente, welche eine nichtlineare Kennlinie aufweisen, an die Spule zu führen. Hierfür ist eine Schaltung vorgesehen, bei der ein Modulationssignal einen SchaltTransistor ansteuert, in dessen Lastkreis je ein nichtlineares Bauelement an je einen Spulenanschluß geführt ist. An die Spulenanschlüsse ist außerdem je eine Diode angeschlossen, wobei die anderen Diodenanschlüsse in einem Knoten verbunden sind, an den ein Shunt-Transistor angeschlossen ist, welcher in erster Linie der Spannungsbegrenzung dient. Da dieser Shunt-Transistor verhältnismäßig langsam ist, ist zwischen dem Knoten und dem Steueranschluß des Shunt-Transistors ein weiterer Transistor angeordnet, welcher der Abregelung schneller Spannungsspitzen dient. Die Verwendung nichtlinearer Bauelemente führt dazu, daß die Reichweite des Transponders signifikant vergrößert werden kann, und außerdem das Auftreten von Funklöchern reduziert wird.

In einer vorteilhaften Ausführungsform der vorliegenden Erfindung sind die Dioden des Spannungsreglers, welche mit den Spulenanschlüssen verbunden sind, zugleich als nichtlineare Bauelemente verwendet, über die das Modulationssignal an die Spulenanschlüsse geführt wird. Diese Modifikation erfordert gegenüber den üblicherweise verwendeten Widerständen keine zusätzliche Silizium- beziehungsweise Chipfläche und ist deshalb vorteilhaft.

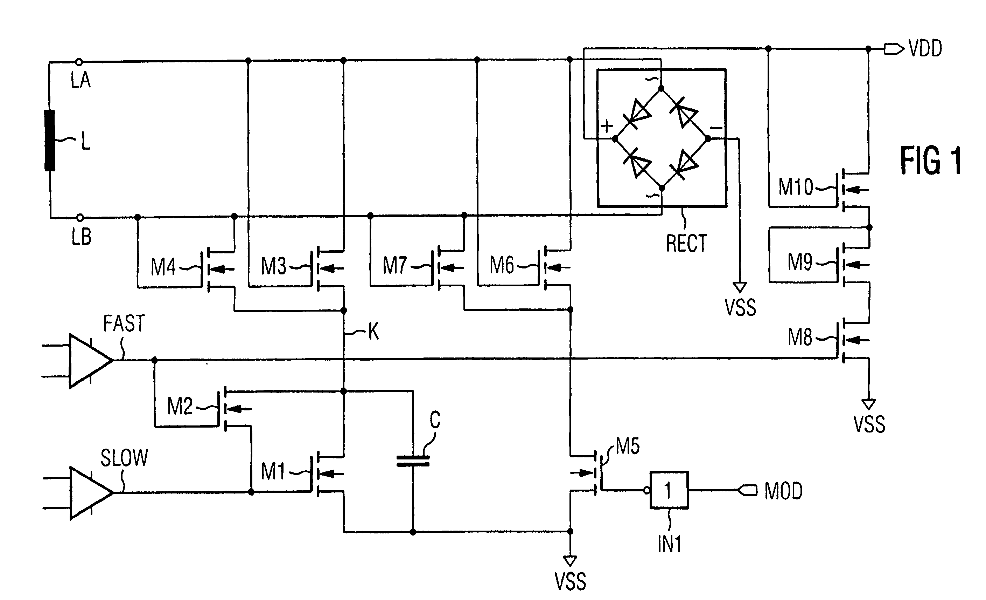

Die Einsparung zweier Hochvolt-Transistoren verringert den benötigten Platz der Schaltung gegenüber der in Figur 1 dargestellten Variante.

In einer weiteren vorteilhaften Ausführungsform der Erfindung wird das bekannte Modulationssignal dem Spannungsregler zugeführt, so daß während eines Modulationsvorgangs der schnelle Regleranteil des Spannungsreglers deaktiviert wird. Dies ist deshalb unproblematisch, weil durch Aufmodulieren des Modulationssignals die Spannung an den Spulenanschlüssen ohnehin reduziert ist und deshalb keine gefährlichen Spannungsspitzen zu erwarten sind. Diese Schaltung weist einen geringen Flächenbedarf auf, da die Dioden des Spannungsreglers zugleich als nichtlineare Bauelemente für die Rückmodulation verwendet werden, außerdem weist diese Schaltung keinerlei nachteilhafte gegenseitige Beeinflussung von Modulationsschaltung und Spannungsregler auf, welche zu instabilem Verhalten des Spannungsreglers führen kann, und schließlich führt die Verwendung nichtlinearer Bauelemente bei der Rückmodulation zu einer deutlich verbesserten Reichweite.

Weitere Einzelheiten und Ausgestaltungen der Erfindung sind in den Unteransprüchen angegeben.

Die Erfindung wird nachfolgend an drei Ausführungsbeispielen anhand der Zeichnungen näher erläutert.

Es zeigen:
- Figur 1: eine erste Ausführungsform der vorliegenden Erfindung mit Trennung von Modulation und Regelung in einer prinzipiellen Anordnung,
- Figur 2: ein zweites Ausführungsbeispiel der vorliegenden Erfindung unter Verwendung der Spannungsregler-Dioden als nichtlineare Bauelemente für die Modulation in einer prinzipiellen Anordnung, und
- Figur 3: ein drittes Ausführungsbeispiel der vorliegenden Erfindung gemäß Figur 2, wobei zusätzlich Modulation und Spannungsregler gegenseitig verriegelt sind, in einer prinzipiellen Anordnung.

In Figur 1 ist eine Spule L mit Anschlüssen LA, LB eingezeichnet, welche eine drahtlose Kopplung des Transponders mit einer Station ermöglicht. An den beiden Spulenanschlüssen LA, LB ist ein Gleichrichter RECT angeschlossen, welcher an seinen Ausgängen VDD, VSS die Spannungsversorgung des Transpondas bereitstellt. Als Dioden geschaltete Transistoren M3, M4 sind mit jeweils einem ihrer Lastanschlüsse an einen der Spulenanschlüsse LA, LB angeschlossen, und mit ihren zweiten Lastanschlüssen in einem Knoten K verbunden. Dieser Knoten K ist ein Lastanschluß eines Shunt-Transistors M1, dessen zweiter Lastanschluß an das Bezugspotential VSS angeschlossen ist. Mit diesem Zweig M1, M3, M4 ist eine langsame Spannungsregelung des Transponders mit einem Parallel- beziehungsweise Shuntregler realisiert. Dem Steuereingang des Shunt-Transistors M1 ist ein langsames Reglersignal SLOW zuführbar, welches in einem nicht vollständig dargestellten Teil der Schaltung aufbereitet ist. Falls an den Spulenanschlüssen LA, LB eine zu hohe Spannung anliegt, so wird der Shunt-Transistor M1 geöffnet. Für schnelle Spannungsspitzen ist ein zusätzlicher Transistor M2 vorgesehen, welcher mit einem ersten Lastanschluß an den Knoten K, und mit einem zweiten Lastanschluß an den Steuereingang des Shunt-Transistors M1 angeschlossen ist. Dem Steuereingang des Hilfs-Transistors M2 ist ein in einer nicht dargestellten Teilschaltung generiertes schnelles Regelsignal FAST zuführbar. Der Hilfs-Transistor M2 hat die Aufgabe, bei schnellen Spannungsspitzen den Knoten K mit dem Steuereingang des Transistors M1 zu verbinden und so das Öffnen des Shunt-Transistors M1 durch schnelles Aufladen des Gates des beispielhaft verwendeten NMOS-FETS zu beschleunigen. Das schnelle Reglersignal FAST ist außerdem noch dem Steueranschluß eines Transistors M8 zuführbar, dessen einer Lastanschluß mit dem Bezugspotential VSS, und dessen anderer Lastanschluß über zwei als Dioden geschaltete Transistoren M9, M10 an das zweite Bezugspotential VDD angeschlossen ist. Der zwischen dem Knoten K und dem Bezugspotential VSS parallel zum Shunttransistor M1 angeordnete Kondensator C hat lediglich eine Stützfunktion. Er kann in Abwandlungen der Schaltung entfallen. Das in einem nicht dargestellten Teil der Schaltung generierte Modulationssignal MOD ist über einen Inverter IN1 dem Steuereingang eines Transistors M5 zuführbar. Der Schaltertransistor M5 weist zwei Lastanschlüsse auf, von denen einer mit dem Bezugspotential VSS verbunden ist, und der andere Lastanschluß mittels jeweils eines nichtlinearen Bauelements M6, M7 an je einen Spulenanschluß LA, LB angeschlossen ist. Im vorliegenden Ausführungsbeispiel sind als nichtlineare Bauelemente Transistoren verwendet, welche als Dioden verschaltet sind. Bei den im ersten Ausführungsbeispiel verwendeten, selbstsperrenden FET-Transistoren wird eine Diodenschaltung durch Verbinden von Gate und Drain des Transistors realisiert. Bei den so verschalteten Transistoren M6, M7, welche eine quadratische Strom-Spannungs-Kennlinie aufweisen, ergibt sich das gewünschte, nichtlineare Modulationsverhalten. Dies hat den Vorteil einer deutlich verbesserten Reichweite des Transponders.

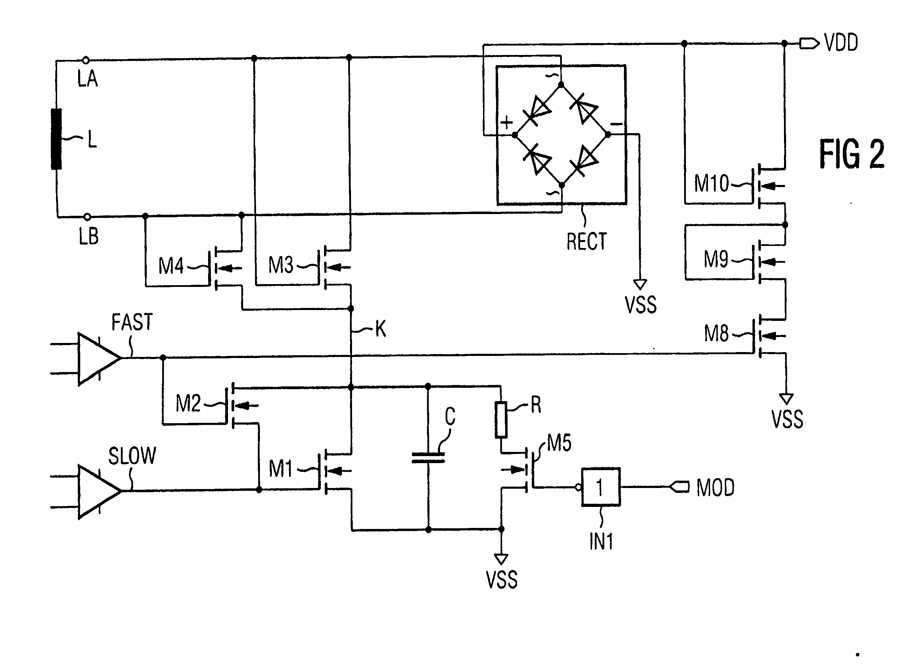

In einer zweiten Ausführungsform der vorliegenden Erfindung gemäß Figur 2 wird Chipfläche dadurch eingespart, daß die Transistoren M3, M4 des Spannungsreglers zugleich als nichtlineare Bauelemente für die Modulationsschaltung verwendet werden. Hierfür ist der Lastanschluß des Transistors M5 über einen Widerstand R an den Knoten K angeschlossen. Diese Abwandlung der Schaltung weist den Vorteil auf, die gewünschte größere Reichweite mit einem geringen Bedarf an Chipfläche zu kombinieren. Bei eingeschaltetem Schalter-Transistor M5 wird nunmehr der Knoten K fast auf Bezugspotential VSS gezogen. Außerdem nehmen bei Modulation auch die Spannungen an den Anschlüssen LA und LB ab. Der langsame Regler kompensiert dies dadurch, daß er den Strom durch M1 reduziert. Dadurch steigt die Spannung an LA langsam an. Als Folge davon beschleunigt der schnelle Regler den langsamen Regler durch Einschalten des Transistors M2. Statt diesen Effekt zu begrenzen, verstärkt der schnelle Regler diesen. Das Gate des NMOS-Transistors M1 wird nunmehr entladen statt aufgeladen. Wenn der Schaltertransistor M5 abgeschaltet wird, schwingt die Spannung an LA zunächst über, bevor einige 100 ns später der schnelle Regler mit dem Hilfstransistor M2 den Effekt korrigiert. Folglich kann die in Figur 2 dargestellte Kopplung von Spannungsregler und Modulation zu Instabilitäten der Schaltung führen.

In einer Abwandlung der Schaltung gemäß Figur 2 kann der Widerstand R auch 0 Ohm betragen.

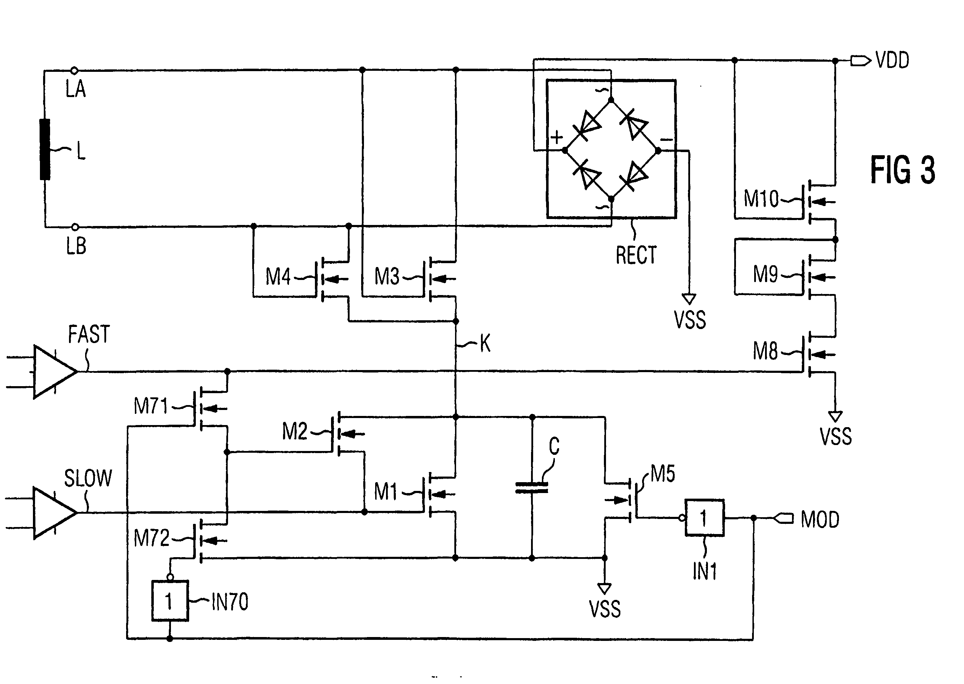

Zur Beseitigung des Nachteils der potentiellen Instabilität, der dadurch entsteht, daß Spannungsregler und Modulation gekoppelt sind, zeigt das Ausführungsbeispiel gemäß Figur 3 eine Abhilfe. Das in einem Inverter IN1 invertierte Modulationssignal, welches dem Schalter-Transistor M5 zuführbar ist, wird in einer gegenüber Figur 2 zusätzlichen Torschaltung zwei Transistoren M71, M72 zugeführt. Der Hilfs-Transistor M2 des schnellen Spannungsreglers ist an diese Torschaltung, beziehungsweise an je einen Lastanschluß der Transistoren M71, M72 angeschlossen. Dem Torschaltungs-Transistor M71 ist das Modulationssignal MOD, dem Torschaltungs-Transistor M72 das in einem Inverter IN70 invertierte Modulationssignal MOD am Steuereingang zuführbar. Einem Lastanschluß des Transistors M71 ist das schnelle Regelsignal FAST zuführbar, der andere ist mit dem Steuereingang des Hilfs-Transistors M2 verbunden. Ein Lastanschluß des Transistors M72 ist ebenfalls mit dem Steuereingang des Hilfs-Transistors M2, der andere mit dem Bezugspotential VSS verbunden. Diese Schaltung hat die Eigenschaft, daß während einer Modulation, das heißt bei geöffnetem Schaltertransistor M5, der schnelle Spannungsregler deaktiviert wird, indem das Gate des Hilfstransistors M2 auf Bezugspotential gezogen wird, während der Schalter-Transistor M5 eingeschaltet ist. Hierdurch ist keine nachteilige gegenseitige Beeinflussung von Modulation und Spannungsregler möglich. Trotzdem können die flächenintensiven Hochvolt-Transistoren M6, M7 entfallen. Die Schaltung gemäß Figur 3 ist also bezüglich Reichweite des Transponders, Flächenbedarf der Schaltung und Regelverhalten des Spannungsreglers während Modulationsvorgängen vorteilhaft.

In Abwandlungen der beschriebenen Ausführungsbeispiele kann die Schaltung auch in PMOS- anstelle von NMOS-Technologie realisiert sein. Außerdem kann der Kondensator C entfallen.

## Patentansprüche

1. Transponder aufweisend eine Modulationsschaltung mit
- einer Spule (L) mit zwei Anschlüssen (LA, LB)an denen ein Gleichrichter (RECT) angeschlossen ist, welche an seinen Ausgängen die Spannungsversorgung des Transponders bereitstellt,
- einem Schalter-Transistor (M5), dessen erster Lastanschluß über je ein nichtlineares Bauelement an je einen Spulenanschluß (LA, LB) angeschlossen ist, dessen zweiter Lastanschluß mit einem Bezugspotential (VSS) verbunden ist, und dessen Steueranschluß ein Modulationssignal (MOD) zuführbar ist, und
**gekennzeichnet durch** einen Spannungsregler, aufweisend
- einen langsamen Regler mit einem Shunt-Transistor (M1), dessen Steueranschluß ein langsames Regelsignal (SLOW) zuführbar ist, und dessen erster Lastanschluß mit dem Bezugspotential (VSS), und dessen zweiter Lastanschluß mit einem Knoten (K) verbunden ist, wobei der Knoten (K) über je eine Diode (M3, M4) mit je einem Spulenanschluß (LA, LB) verbunden ist, und aufweisend
- einen schnellen Spannungsregler, mit einem Hilfs-Transistor (M2), dessen Steueranschluß ein schnelles Regelrsignal (FAST) zuführbar ist und dessen erster Lastanschluß mit dem Knoten (K), und dessen zweiter Lastanschluß mit dem Steueranschluß des Shunt-Transistors (M1) verbunden ist.

2. Transponder nach Anspruch 1,
**dadurch gekennzeichnet, daß**
die Dioden Transistoren (M3, M4) sind, welche als Dioden geschaltet sind.

3. Transponder nach Anspruch 1 oder 2,
**dadurch gekennzeichnet, daß**
die nichtlinearen Bauelemente als Dioden geschaltete Transistoren (M6, M7) sind.

4. Transponder nach Anspruch 1 oder 2,
**dadurch gekennzeichnet, daß**
der erste Lastanschluß des Schalter-Transistors (M5) an den Knoten (K) über einen Widerstand (R) angeschlossen ist, so daß die Dioden (M3, M4) zugleich die nichtlinearen Bauelemente sind.

5. Transponder nach Anspruch 4,
**dadurch gekennzeichnet, daß**
der Widerstand (R) gleich 0 Ohm ist.

6. Transponder nach Anspruch 4 oder 5,
**dadurch gekennzeichnet, daß**
das Modulationssignal (MOD) dem Steueranschluß eines ersten Torschaltungs-Transistors (M71) zuführbar ist, dessen erstem Lastanschluß das schnelle Reglersignal (FAST) zuführbar ist, und dessen zweiter Lastanschluß an den Steuereingang des Hilfstransistors (M2) angeschlossen ist, und daß das Modulationssignal (MOD) über einen Inverter (IN 70) dem Steuereingang eines zweiten Torschaltungs-Transistors (M72) zuführbar ist, dessen erster Lastanschluß mit dem Steueranschluß des Hilfstransistors (M2), und dessen zweiter Lastanschluß mit dem Bezugspotential (VSS) verbunden ist.

7. Transponder nach einem der Ansprüche 1 bis 6,
**dadurch gekennzeichnet, daß**
ein Kondensator (C) zwischen den Knoten (K) und das Bezugspotential (VSS) geschaltet ist.

8. Transponder nach einem der Ansprüche 1 bis 7,
**dadurch gekennzeichnet, daß**
ein Gleichrichter (RECT) vorgesehen ist, dessen Eingänge an die Spulenanschlüsse (LA, LB) angeschlossen sind, und an dessen Ausgängen das Bezugspotential (VSS) und ein zweites Potential (VDD) abgreifbar sind.

9. Transponder nach einem der Ansprüche 1 bis 8,
**dadurch gekennzeichnet, daß**
das Modulationssignal (MOD) dem Steueranschluß des SchaltTransistors (M5) über einen Inverter (IN1) zuführbar ist.

## Claims

1. Transponder having a modulation circuit with
- a coil (L) having two connections (LA, LB) to which a rectifier (RECT), whose outputs provide the voltage supply for the transponder, is connected,
- a switch transistor (M5) whose first load connection is connected to a respective coil connection (LA, LB) via a respective non-linear component, whose second load connection is connected to a reference potential (VSS) and whose control connection can be supplied with a modulation signal (MOD), and
**characterized by** a voltage controller having
- a slow controller with a shunt transistor (M1) whose control connection can be supplied with a slow control signal (SLOW), whose first load connection is connected to the reference potential (VSS) and whose second load connection is connected to a node (K), the node (K) being connected to a respective coil connection (LA, LB) via a respective diode (M3, M4), and having
- a fast voltage controller with an auxiliary transistor (M2) whose control connection can be supplied with a fast controller signal (FAST), whose first load connection is connected to the node (K) and whose second load connection is connected to the control connection of the shunt transistor (M1).

2. Transponder according to Claim 1,
**characterized in that**
the diodes are transistors (M3, M4) which are connected as diodes.

3. Transponder according to Claim 1 or 2,
**characterized in that**
the non-linear components are transistors (M6, M7) which are connected as diodes.

4. Transponder according to Claim 1 or 2,
**characterized in that**
the first load connection of the switch transistor (M5) is connected to the node (K) via a resistor (R), with the result that the diodes (M3, M4) are simultaneously the non-linear components.

5. Transponder according to Claim 4,
**characterized in that**
the resistance (R) is equal to 0 ohms.

6. Transponder according to Claim 4 or 5,
**characterized in that**
the modulation signal (MOD) can be supplied to the control connection of a first gate transistor (M71) whose first load connection can be supplied with the fast controller signal (FAST) and whose second load connection is connected to the control input of the auxiliary transistor (M2), and **in that** the modulation signal (MOD) can be supplied, via an inverter (IN 70), to the control input of a second gate transistor (M72) whose first load connection is connected to the control connection of the auxiliary transistor (M2) and whose second load connection is connected to the reference potential (VSS).

7. Transponder according to one of Claims 1 to 6,
**characterized in that**
a capacitor (C) is connected between the node (K) and the reference potential (VSS).

8. Transponder according to one of Claims 1 to 7,
**characterized in that**
a rectifier (RECT) is provided, the inputs of which are connected to the coil connections (LA, LB) and at the outputs of which the reference potential (VSS) and a second potential (VDD) can be tapped off.

9. Transponder according to one of Claims 1 to 8,
**characterized in that**
the modulation signal (MOD) can be supplied to the control connection of the switching transistor (M5) via an inverter (IN1).

## Revendications

1. Transpondeur ayant un circuit de modulation comprenant
- une bobine (L) ayant deux bornes (LA, LB) auxquelles est relié un redresseur (RECT) qui procure sur ses sorties l'alimentation en tension du transpondeur ;
- un transistor commutateur (M5) dont la première borne de charge est reliée à, respectivement, une borne (LA, LB) de la bobine par, respectivement, un composant non linéaire, à la deuxième borne de charge duquel est appliqué un potentiel (VSS) de référence et à la borne de commande duquel peut être envoyé un signal (MOD) de modulation ; et
**caractérisé par** un régulateur de tension comprenant
- un régulateur lent ayant un transistor shunt (M1) à la borne de commande duquel peut être envoyé un signal (SLOW) lent de régulation et à la première borne de charge duquel est appliqué le potentiel (VSS) de référence et dont la deuxième borne de charge est reliée à un noeud (K), le noeud (K) étant relié par, respectivement, une diode (M3, M4) à, respectivement, une borne (LA, LB) de la bobine et comprenant
- un régulateur rapide de tension ayant un transistor auxiliaire (M2) à la borne de commande duquel peut être envoyé un signal (FAST) rapide de régulation et dont la première borne de charge est reliée au noeud (K) et dont la deuxième borne de charge est reliée à la borne de commande du transistor shunt (M1).

2. Transpondeur suivant la revendication 1,
**caractérisé en ce que** les diodes sont des transistors (M3, M4) qui sont montés en diode.

3. Transpondeur suivant la revendication 1 ou 2,
**caractérisé en ce que** les composants non linéaires sont des transistors (M6, M7) montés en diode.

4. Transpondeur suivant la revendication 1 ou 2,
**caractérisé en ce que** la première borne de charge du transistor commutateur (M5) est reliée au noeud (K) par une résistance (R), de sorte que les diodes (M3, M4) sont en même temps les composants non linéaires.

5. Transpondeur suivant la revendication 4,
**caractérisé en ce que** la résistance (R) est égale à 0 ohm.

6. Transpondeur suivant la revendication 4 ou 5,
**caractérisé en ce que** le signal (MOD) de modulation peut être envoyé à la borne de commande d'un premier transistor de circuit porte (M71) à la première borne de charge duquel peut être envoyé le signal (FAST) rapide du régulateur et dont la deuxième borne de charge est reliée à l'entrée de commande du transistor auxiliaire (M2) et **en ce que** le signal (MOD) de modulation peut être envoyé par un inverseur (IN70) à l'entrée de commande d'un deuxième transistor de circuit porte (M72), dont la première borne de charge est reliée à la borne de commande du transistor auxiliaire (M2) et à la deuxième borne de charge duquel s'applique le potentiel (VSS) de référence.

7. Transpondeur suivant l'une des revendications 1 à 6,
**caractérisé en ce qu'**un condensateur (C) est monté entre le noeud (K) et le potentiel (VSS) de référence.

8. Transpondeur suivant l'une des revendications 1 à 7,
**caractérisé en ce qu'**il est prévu un redresseur (RECT) dont les entrées sont reliées aux bornes (LA, LB) de la bobine et aux sorties duquel peuvent être prélevés le potentiel (VSS) de référence et un deuxième potentiel (VDD).

9. Transpondeur suivant l'une des revendications 1 à 8,
**caractérisé en ce que** le signal (MOD) de modulation peut être envoyé à la borne de commande du transistor commutateur (M5) par un inverseur (IN1).
